# EUROPÄISCHE PATENTSCHRIFT

(11) **EP 3 484 051 B1**
(45) Veröffentlichungstag und Bekanntmachung des Hinweises auf die Patenterteilung: **14.04.2021**
(21) Anmeldenummer: 18205432.0
(22) Anmeldetag: 09.11.2018
(51) Int. Cl.: H03K 19/003, G08B 13/08

(54) **VORRICHTUNG MIT EINEM SENSOR UND EINEM BETÄTIGER UND VERFAHREN ZUM TESTEN DER VORRICHTUNG**
DEVICE WITH A SENSOR AND AN ACTUATOR AND METHOD FOR TESTING THE DEVICE
DISPOSITIF DOTÉ D'UN CAPTEUR ET D'UN ACTIONNEUR ET PROCÉDÉ D'ESSAI DUDIT DISPOSITIF

(30) Priorität: 09.11.2017 CH 13532017
(43) Veröffentlichungstag der Anmeldung: 15.05.2019
(73) Patentinhaber: ELESTA GmbH, 7310 Bad Ragaz (CH)
(72) Erfinder: Geges, Norbert, 7323 Vilters (CH); Guntli, Andreas, 8880 Walenstadt (CH); Möhr, Raphael, 7304 Maienfeld (CH); Lukas, Verena, 7205 Zizers (CH); Steiner, Roman, 8725 Ernetschwil (CH); Zöschg, Dietmar R., 8824 Schönenberg (CH)
(74) Vertreter: Riederer Hasler & Partner Patentanwälte AG

(56) Entgegenhaltungen:
- EP-A1- 0 244 311
- US-A- 3 641 552
- US-A- 5 633 626

## Beschreibung

### Technisches Gebiet

Beschrieben ist eine Vorrichtung, geeignet zum Überwachen einer Schliessposition zweier relativ zueinander beweglicher Teile, insbesondere zur Verwendung als Türkontaktschalter zum Beispiel bei einer Schutztür zum Absichern einer automatisiert arbeitenden technischen Anlage.

Die Vorrichtung beinhaltet einen Betätiger und einen Sensor, sowie Komponenten zum Testen der Vorrichtung.

Zudem wird ein Verfahren zum Testen der Vorrichtung beschrieben.

### Stand der Technik

Bei automatisiert arbeitenden technischen Anlagen, die eine Gefahr für die menschliche Gesundheit darstellen, muss sichergestellt werden, dass bei einer Änderung der Stellung einer den Zugang zur Anlage kontrollierenden Schutzeinrichtung Massnahmen zur Gefahrenminderung eingeleitet, also beispielsweise ein Alarm ausgelöst und/oder die Anlage ausgeschaltet werden.

Es ist bekannt, zur Überwachung der Stellung einer Schutzeinrichtung, wie zum Beispiel einer Schutztür oder einer Maschinenverkleidung, Sicherheitsschalter einzusetzen. Solche Sicherheitsschalter weisen üblicherweise einen Sensor und einen Betätiger auf, wobei der Schaltzustand des Sicherheitsschalters vom Abstand des Betätigers vom Sensor abhängt. Durch das Anbringen des Sensors an einem und des Betätigers am anderen von zwei relativ zueinander beweglichen Teilen, wie zum Beispiel einer Türzarge und einem Türblatt einer Schutztüre, kann die Schliessposition der Schutzeinrichtung überwacht werden.

Um die Funktionstüchtigkeit eines solchen Sicherheitsschalters während seiner gesamten Betriebszeit sicherstellen zu können, ist eine Funktionsprüfung notwendig, die vorliegend in Form einer Selbstdiagnose erfolgt. Durch eine solche Selbstdiagnose ist es möglich, Fehler, während der Betriebszeit im Sicherheitsschalter auftreten, zu entdecken.

Aus der EP0969600A1 ist ein nicht sicherer Näherungsschalter mit einem Sensor, einer Weiterverarbeitungseinheit und einem Mikroprozessor bekannt. Die Weiterverarbeitungseinheit (Empfangskreis) dient zur Verarbeitung eines im Normalbetrieb vom Sensor empfangenen Analogsignals und der anschliessenden Weiterleitung an den Mikroprozessor zur dortigen Auswertung. Der Mikroprozessor ist zudem über ein Netzwerk mit dem Eingang der Weiterverarbeitungseinheit verbunden und kann so zur Funktionsprüfung der Weiterverarbeitungseinheit ein Prüfsignal zuführen. Der Nachteil dieser Vorrichtung besteht darin, dass die Weiterverarbeitungseinheit für sicherheitsrelevante Anwendungen nicht in ausreichendem Masse überprüft werden kann. Es können nur die Empfindlichkeit des Verstärkers und die Verstärkung überprüft werden. Dieses Verfahren ist für eine komplexe Überprüfung der Weiterverarbeitungseinheit nicht geeignet, weil weitere für sicherheitsrelevante Anwendungen notwendige Komponenten wie Transceiver und Speichereinheit des Transceivers nicht mitgetestet werden können.

Die US5636226 (D1)offenbart eine Schaltanlage mit einer Selbsttest-Funktion für die Überprüfung der Schliessung einer gerahmten Öffnung durch ein bewegliches Stück wie zum Beispiel einer Türe oder eines Fensters. Für die Überprüfung der Schliessung ist am Rahmen der Öffnung eine Schalteinheit mit Schaltern angebracht, welche durch einen elektrischen Kreislauf untereinander in Verbindung stehen. Das bewegliche Stück weist ein oder mehrere permanente Magnete auf, welche bei geschlossenem Zustand der Öffnung die Schalter am Rahmen in einen ersten Zustand versetzen. Beim Öffnen der Öffnung verlieren die Magnete am beweglichen Stück ihre elektromagnetische Wirkung auf die Schalter. Daraufhin werden diese Schalter in einen zweiten Zustand versetzt und lösen einen Alarm aus. Die Schaltanlage verfügt über eine Selbsttest-Funktion, welche bei geschlossenem Zustand der Öffnung zur Anwendung kommt. Die Selbsttest-Funktion verursacht eine Änderung der elektrischen Signale, so dass die elektromagnetische Wirkung der Magnete am beweglichen Stück aufgelöst wird und damit das Öffnen der Öffnung simuliert wird. Mit Hilfe der Selbsttest-Funktion kann von beliebiger Stelle heraus die Antwort auf das Öffnen der Öffnung geprüft werden, ohne etwas notwendigerweise in Bewegung zu versetzen.

### Aufgabe der Erfindung

Es ist eine Aufgabe der vorliegenden Erfindung, eine alternative Vorrichtung vorzuschlagen, die zum Überwachen einer Schliessposition zweier relativ zueinander beweglicher Teile und insbesondere zur Verwendung als Türkontaktschalter geeignet ist.

Die Vorrichtung soll vorteilhaft dazu in der Lage sein, eine Funktionsprüfung von Komponenten des Empfangskreises durchzuführen und es wird ein Verfahren zu diesem Zweck vorgeschlagen.

Weitere Vorteile der vorliegenden Erfindung ergeben sich aus der nachfolgenden Beschreibung.

### Darstellung der Erfindung

Die oben genannte Aufgabe wird gelöst durch eine Vorrichtung nach Anspruch 1.

Die Erfindung beinhaltet eine Vorrichtung, insbesondere ein Türkontaktschalter, beinhaltend einen Sensor und einen Betätiger. Die Vorrichtung besitzt zwei Betriebszustände: Einen Normalbetriebszustand (kurz "Normalbetrieb") und einen Testbetriebszustand (kurz "Testbetrieb"). Der Sensor weist einen Empfangskreis auf, der ein Sensorelement, ein Empfangskreis-Signal und ein Detektorelement beinhaltet. Weiter weist der Sensor eine mit dem Detektorelement verbundene Recheneinheit auf. Das Sensorelement ist dazu ausgebildet, im Normalbetrieb mit dem Betätiger zur Erzeugung eines ersten Empfangskreis-Signals zusammenzuwirken, wenn eine Schaltentfernung zwischen Sensorelement und Betätiger unterschritten wird. Das Detektorelement ist dazu ausgebildet, in Abhängigkeit des (insbesondere aus dem) ersten Empfangskreis-Signals ein erstes Ausgangs-Signal zu erzeugen und an die Recheneinheit zu übermitteln. Zusätzlich weist der Empfangskreis einen Signalemulator und ein Umschaltelement auf, wobei die Vorrichtung mittels des Umschaltelements zwischen Normalbetrieb und Testbetrieb umschaltbar ist und wobei das Empfangskreis-Signal durch eine kontinuierliche Abfolge von Datenpaketen gebildet ist. Der Signalemulator ist dazu ausgebildet, im Testbetrieb ein zweites Empfangskreis-Signal zu erzeugen, wobei das Detektorelement dazu ausgebildet ist, in Abhängigkeit des (insbesondere aus dem) zweiten Empfangskreis-Signals ein zweites Ausgangs-Signal zu erzeugen und an die Recheneinheit zu übermitteln.

Optional kann die Recheneinheit dann in Abhängigkeit eines oder mehrerer der empfangenen Ausgangs-Signale Massnahmen einleiten, insbesondere ein Signal erzeugen (zum Beispiel ein Freigabe-Signal oder ein Fehler-Signal) und/oder einen Schaltzustand oder den Betriebszustand der Vorrichtung ändern (zum Beispiel die Vorrichtung ausschalten oder sie in den Zustand versetzen, der vorherrscht, wenn im Normalzustand eine Schaltentfernung zwischen Sensor und Betätiger nicht unterschritten ist).

Zudem ist ein Verfahren zur Prüfung einer Vorrichtung, wie sie in diesem Dokument beschrieben ist, offenbart. Im Verfahren wird die Vorrichtung mittels des Umschaltelements vom Normalbetrieb auf den Testbetrieb umgeschaltet, der Signalemulator erzeugt ein zweiten Empfangskreis-Signal und das Detektorelement erzeugt (aus dem und/ oder) in Abhängigkeit des zweiten Empfangskreis-Signals ein zweites Ausgangs-Signal, wobei das zweite Ausgangs-Signal an die Recheneinheit übermittelt wird. Insbesondere kann der Signalemulator so das Sensorelement emulieren.

Nachfolgend werden Merkmale beschrieben, wobei diese (individuell) als bevorzugte Merkmale zu betrachten sind, auch wenn sie nicht explizit als solche bezeichnet werden. Die Merkmale seien separat (als Teil einer beliebigen Vorrichtung oder eines beliebigen Verfahrens) und - soweit sie sich nicht ausschliessen - in beliebiger Kombination offenbart. Dies schliesst die Möglichkeit der gleichzeitigen Verwirklichung aller beschriebenen Merkmale ein.

Bei der Vorrichtung handelt es sich mit Vorteil um eine Vorrichtung zur Überwachung eines Abstands und/oder einer relativen Position (insbesondere einer Schliessposition) zweier relativ zueinander beweglicher Teile. Der Betätiger ist dabei zur Befestigung am einen Teil (beispielsweise einem Türblatt) ausgebildet und der Sensor ist zur Befestigung am anderen Teil (beispielsweise einer Türzarge) ausgebildet.

Die Vorrichtung ist unter anderem geeignet zur Überwachung der Stellung einer Schutzeinrichtung (z.B. einer Schutztür oder einer Maschinenverkleidung). Eine solche Schutzeinrichtung kann den Zugang zu einer Gefahrenzone (z.B. einem Raum mit einem gefährlichen Maschinenteil) kontrollieren. Insbesondere kann es sich bei der Vorrichtung um einen Türkontaktschalter für eine Schutztüre zum Absichern einer automatisch arbeitenden Anlage handeln.

Bei der Vorrichtung handelt es sich mit Vorteil um einen Schalter, insbesondere einen Sicherheitsschalter und/oder einen Türkontaktschalter und/oder einen Näherungsschalter. Durch eine Änderung der Stellung der genannten Schutzeinrichtung und/oder des Abstands zwischen den genannten relativ zueinander beweglichen Teilen kann eine Änderung des Schaltzustands des genannten Schalters herbeigeführt werden. In Abhängigkeit des Schaltzustands des Schalters können wiederum weitere Massnahmen ergriffen werden. Insbesondere kann als Massnahme eine zweite Vorrichtung wie zum Beispiel eine Alarmanlage, ein Schliessmechanismus, die Stromzufuhr zu einer Maschine etc. betätigt (insbesondere aktiviert oder deaktiviert) werden.

Die Vorrichtung, insbesondere zur Verwendung als Türkontaktschalter, beinhaltet einen Sensor und einen Betätiger.

Beim Sensor kann es sich beispielsweise um einen optischen, einen elektrischen (insbesondere einen kapazitiven oder induktiven) oder einen mechanischen Sensor oder um einen Ultraschall-Sensor handeln.

Der Sensor weist ein Sensorelement, ein Detektorelement, einen Signalemulator und ein Umschaltelement auf, wobei diese Komponenten vorzugsweise einen Empfangskreis bilden und/ oder Teile eines Empfangskreises sind. Darüber hinaus beinhaltet der Sensor eine Recheneinheit.

Beim Sensorelement kann es sich beispielsweise um eine Empfängerspule, eine Photodiode oder einen Phototransistor handeln.

Das Sensorelement ist mit dem Detektorelement (insbesondere physisch und/oder elektrisch) verbunden oder verbindbar und/oder gekoppelt oder koppelbar (insbesondere durch das Umschaltelement).

Sinnvollerweise ist das Sensorelement zumindest im Normalbetrieb der Vorrichtung mit dem Detektorelement (insbesondere physisch und/oder elektrisch) verbunden und/ oder gekoppelt. Alternativ oder zusätzlich ist im Normalbetrieb eine Signalübermittlung (insbesondere des ersten Empfangskreis-Signals) vom Sensorelement an das Detektorelement vorgesehen und/oder möglich.

Im Testbetrieb der Vorrichtung kann das Sensorelement mit dem Detektorelement (insbesondere physisch und/oder elektrisch) verbunden und/ oder gekoppelt sein oder das Sensorelement kann dann von diesem (insbesondere physisch und/oder elektrisch) getrennt und/ oder entkoppelt sein. Letzteres ist bevorzugt weil dann Normalbetrieb und Testbetrieb unabhängig voneinander sind. Alternativ oder zusätzlich ist im Testbetrieb eine Signalübermittlung (insbesondere des ersten Empfangskreis-Signals) vom Sensorelement an das Detektorelement nicht möglich.

Der Sensor und/oder das Sensorelement sind dazu ausgebildet, (insbesondere im Normalbetrieb der Vorrichtung) mit dem Betätiger zusammenzuwirken, wenn eine definierte Schaltentfernung zwischen Sensor und Betätiger unterschritten wird. Die Schaltentfernung kann zum Beispiel kleiner als 500, 50,10 oder 5 Millimeter sein. Durch das Zusammenwirken wird ein erstes Empfangskreis-Signal durch das Sensorelement und/oder im Empfangskreis erzeugt. Handelt es sich bei der Vorrichtung um einen Schalter, so kann alternativ oder zusätzlich durch das Zusammenwirken der Schaltzustand der Vorrichtung geändert werden.

Zweckmässigerweise handelt es sich beim ersten Empfangskreis-Signal um ein definiertes Empfangskreis-Signal.

Nach einer Variante kann das erste Empfangskreis-Signal in Abhängigkeit des Betätigers vom Sensorelement erzeugt werden. Wenn es sich beim Betätiger um einen RFID-Betätiger handelt kann das erste Empfangskreis-Signal also zum Beispiel spezifisch für den RFID-Betätiger ausgebildet sein.

Der Sensor weist einen Signalemulator auf. Der Signalemulator ist mit dem Detektorelement (insbesondere physisch und/oder elektrisch) verbunden oder verbindbar und/ oder gekoppelt oder koppelbar (insbesondere durch das Umschal telement) .

Sinnvollerweise ist der Signalemulator zumindest im Testbetrieb der Vorrichtung mit dem Detektorelement (insbesondere physisch und/oder elektrisch) verbunden und/oder gekoppelt. Alternativ oder zusätzlich ist im Testbetrieb eine Signalübermittlung (insbesondere des emulierten Empfangskreis-Signals) vom Signalemulator an das Detektorelement möglich.

Im Normalbetrieb der Vorrichtung kann der Signalemulator mit dem Detektorelement (insbesondere physisch und/oder elektrisch) verbunden und/oder gekoppelt sein oder der Signalemulator kann dann von diesem (insbesondere physisch und/oder elektrisch) getrennt und/oder entkoppelt sein. Letzteres ist bevorzugt weil dann Normalbetrieb und Testbetrieb unabhängig voneinander sind. Alternativ oder zusätzlich ist im Normalbetrieb eine Signalübermittlung (insbesondere des emulierten Empfangskreis-Signals) vom Signalemulator an das Detektorelement nicht möglich und/oder nicht vorgesehen.

Vorteilhaft ist der Signalemulator mit der Recheneinheit (insbesondere physisch und/oder elektrisch) verbunden und/oder gekoppelt.

Im Testbetrieb wird ein emuliertes Empfangskreis-Signal, insbesondere das zweite Empfangskreis-Signal, durch den Signalemulator und/oder im Empfangskreis erzeugt.

Insbesondere kann der Signalemulator dazu ausgebildet sein, während desselben Testbetriebs oder während anderer Testbetriebe (d.h. solcher Testbetriebe, die davon und/oder voneinander durch mindestens einen Wechsel in den Normalbetrieb getrennt sind) ein oder mehrere (zum Beispiel mindestens 5, 10 oder 50 und/oder höchstens 500 oder 100) weitere, sich vom zweiten Empfangskreis-Signal und/oder voneinander unterscheidende emulierte Empfangskreis-Signale zu erzeugen. Das Detektorelement kann dann dazu ausgebildet sein, aus und/oder in Abhängigkeit von den ein oder mehreren weiteren emulierten Empfangskreis-Signalen jeweils ein emuliertes Ausgangs-Signal zu erzeugen und an die Recheneinheit zu übermitteln.

Das emulierte Empfangskreis-Signal kann konstant oder wechselnd (insbesondere in Bezug auf die Signalstärke, Frequenz und/oder die weiter unten beschriebene Abfolge von Datenpaketen) ausgestaltet sein.

Es kann von Vorteil sein, wenn das emulierte Empfangskreis-Signal, insbesondere das zweite Empfangskreis-Signal, und/oder die weiteren emulierten Empfangskreis-Signale, stärker als das erste Empfangskreis-Signal sind, zum Beispiel mindestens 2, 5 oder 10 mal so stark.

Bevorzugt ist der Signalemulator dazu ausgebildet, aus und/oder in Abhängigkeit des zweiten Steuersignals das zweite Empfangskreis-Signal zu erzeugen. Das zweite Steuersignal wird an den Signalemulator übermittelt, wobei das zweite Steuersignal vorzugsweise von der Recheneinheit erzeugt und/oder von dieser an den Signalemulator übermittelt wird.

Beispielsweise kann der Signalemulator dazu ausgebildet sein, das zweite Empfangskreis-Signal durch Aufmodulieren des zweiten Steuersignals auf eine Trägerwelle zu erzeugen. Die Trägerwelle kann zum Beispiel vom Detektorelement erzeugt werden und/oder das Detektorelement kann das zweite Ausgangs-Signal durch Demodulation des zweiten Empfangskreis-Signals erzeugen. Alternativ oder zusätzlich kann der Signalemulator von der Recheneinheit gesteuert werden.

Beim ersten Empfangskreis-Signal und/oder beim emulierten Empfangskreis-Signal handelt es sich mit Vorteil um ein moduliertes (insbesondere digital moduliertes) Analog-Signal.

Vorzugsweise bestimmen der Signalemulator und die Recheneinheit zusammen die Signalform des zweiten Empfangskreis-Signals. So kann die Recheneinheit via den Signalemulator eine ihm bekannte Signalform definieren. Anhand des daraufhin empfangenen Ausgabe-Signals kann die Recheneinheit feststellen, ob das Detektorelement ordnungsgemäss funktioniert oder nicht.

Beim Detektorelement kann es sich beispielsweise um einen Transceiver, einen Verstärker, einen Empfänger, einen Demodulator und/oder einen Konverter handeln. Das Detektorelement ist mit der Recheneinheit verbunden.

Das Detektorelement ist dazu ausgebildet, bei Empfang des ersten und/oder eines emulierten Empfangskreis-Signals und/ oder in Abhängigkeit des ersten und/ oder eines emulierten Empfangskreis-Signals ein erstes und/ oder ein emuliertes Ausgangs-Signal zu erzeugen und an die Recheneinheit zu übermitteln.

Das Detektorelement kann das genannte Ausgangs-Signal beispielsweise erzeugen, indem es das genannte Empfangskreis-Signal verarbeitet, insbesondere umwandelt (zum Beispiel decodiert und/oder demoduliert). Alternativ oder zusätzlich kann es sich bei den Ausgangs-Signalen um decodierte Informationssignale handeln, die durch Decodieren der Empfangskreis-Signale mittels des Detektorelements erzeugt wurden.

Es ist von Vorteil, wenn das Detektorelement dazu ausgebildet ist, alle Empfangskreis-Signale mit demselben Verfahren und/oder in gleicher Weise zu verarbeiten.

Vorzugsweise kann das Detektorelement nicht zwischen unterschiedlichen Empfangskreis-Signalen unterscheiden. Ein solches Detektorelement kann einfach geprüft werden.

Insbesondere ist das Detektorelement dazu ausgebildet, bei Empfang des ersten Empfangskreis-Signals und/oder in Abhängigkeit des ersten Empfangskreis-Signals ein erstes Ausgangs-Signal zu erzeugen und an die Recheneinheit zu übermitteln, wobei vorzugsweise das erste Empfangskreis-Signal zur Erzeugung des ersten Ausgangs-Signals decodiert wird. Das Detektorelement ist mit Vorteil dazu ausgebildet, bei Empfang des emulierten Empfangskreis-Signals und/oder in Abhängigkeit des emulierten Empfangskreis-Signals ein emuliertes Ausgangs-Signal zu erzeugen und an die Recheneinheit zu übermitteln, wobei vorzugsweise das emulierte Empfangskreis-Signal zur Erzeugung des emulierten Ausgangs-Signals decodiert wird.

Nach einer Variante ist das Detektorelement dazu ausgebildet, eine Trägerwelle zu erzeugen. In diesem Fall kann das Sensorelement dazu ausgebildet sein, ein Signal auf die Trägerwelle aufzumodulieren, wodurch das erste Empfangskreis-Signal gebildet wird und/oder der Signalemulator kann dazu ausgebildet sein, ein Signal (insbesondere das zweite Steuersignal) auf die Trägerwelle aufzumodulieren, wodurch das emulierte Empfangskreis-Signal gebildet wird. Die Erzeugung des ersten und/oder des emulierten Ausgangs-Signals kann dann, wie oben beschrieben, durch Demodulation erfolgen.

Das Detektorelement kann dazu ausgebildet sein, das erste und/oder das emulierte Empfangskreissignal zu verstärken.

Weiter kann das Detektorelement dazu ausgebildet sein, das erste und/oder das emulierte Empfangskreissignal von einem analogen in ein digitales Signal umzuwandeln.

Es kann zweckmässig sein, wenn das Detektorelement das erste und/ oder das emulierte Empfangskreissignal speichert und zu diesem Zweck einen Speicher aufweist (vgl. auch unten).

Weiter weist der Sensor ein Umschaltelement auf, wobei das Umschaltelement zur Umschaltung der Vorrichtung vom Normalbetrieb auf den Testbetrieb und vom Testbetrieb auf den Normalbetrieb ausgebildet ist.

Insbesondere zu diesem Zweck kann das Sensorelement und/oder der Signalemulator mittels des Umschaltelements mit dem Detektorelement verbunden und/oder gekoppelt sowie (insbesondere physisch und/oder elektrisch und/oder durch Unterbruch einer Leitung) vom Detektorelement getrennt und/oder entkoppelt werden. Eine vollständige und/oder physische Trennung und/ oder Entkopplung ist bevorzugt.

Weiter kann das Umschaltelement mit der Recheneinheit (insbesondere physisch und/oder elektrisch) verbunden und/oder gekoppelt sein.

Nach einer bevorzugten Variante ist das Umschaltelement dazu ausgebildet, in Abhängigkeit eines ersten Steuersignals eine oder mehrere der oben genannten Aktionen (insbesondere die Umschaltung zwischen Normalbetrieb und Testbetrieb) vorzunehmen. Das erste Steuersignal wird an das Umschaltelement übermittelt, wobei das erste Steuersignal vorzugsweise von der Recheneinheit erzeugt und/oder von dieser an das Umschaltelement übermittelt wird.

Alternativ oder zusätzlich kann das Umschaltelement von der Recheneinheit gesteuert werden.

Die Vorrichtung und/oder die Recheneinheit kann dazu ausgebildet und/oder programmiert sein, mittels des Umschaltelements widerholt, insbesondere periodisch oder aperiodisch, vom Normalbetrieb in den Testbetrieb und/oder vom Testbetrieb in den Normalbetrieb umzuschalten.

Die Periode der Prüfung (Zeit zwischen dem Start eines Testbetriebs und dem Start des nächsten Testbetriebs) kann mit Vorteil mindestens 5, 10 oder 20 Millisekunden und/oder höchstens 80, 60 oder 40 Millisekunden betragen.

Die Prüfungsdauer (Dauer eines Testbetriebs) kann mit Vorteil mindestens 2, 4 oder 5 Millisekunden und/oder höchstens 20,15 oder 10 Millisekunden betragen.

Der Signalemulator und das Umschaltelement können als getrennte Elemente ausgebildet sein oder ein gemeinsames Element bilden.

Die Informationen, die vom ersten und/ oder vom emulierten Empfangskreis-Signal transportiert werden, können in der Form einer Abfolge von Datenpaketen strukturiert sein. Gemäss einer Varianten können die Informationen eine Zahlenfolge umfassen. Wenn es sich beim Betätiger um einen RFID-Tag handelt, können die besagten Informationen zum Beispiel die dem RFID-Tag zugeordnete Nummer beinhalten.

Es ist von Vorteil, wenn die Umschaltung der Vorrichtung mittels des Umschaltelements vom Normalbetrieb auf den Testbetrieb und/oder vom Testbetrieb auf den Normalbetrieb in Abhängigkeit der Abfolge der Datenpakete des ersten und/oder des emulierten Empfangskreis-Signals erfolgt. Insbesondere kann die besagte Umschaltung zwischen zwei aufeinanderfolgenden Datenpaketen des ersten Empfangskreis-Signals und/ oder des emulierten Empfangskreis-Signals erfolgen.

Nach einer Ausgestaltungsvariante beinhaltet die Abfolge der Datenpakete des ersten und/ oder des emulierten Empfangskreis-Signals jeweils mehrere (zum Beispiel mindestens 2, 5 oder 10 und/oder höchstens 100, 50 oder 20) unterschiedliche Datenpakete.

Alternativ kann die Abfolge der Datenpakete des ersten und/ oder des emulierten Empfangskreis-Signals auch nur jeweils ein sich wiederholendes Datenpaket beinhalten.

Das erste Empfangskreis-Signal und das zweite Empfangskreis-Signal können identisch ausgestaltet sein und/oder die Erzeugung von identischen Ausgangs-Signalen zur Folge haben. Auf diese Weise kann das Sensorelement vom Signalemulator emuliert werden.

Das erste Empfangskreis-Signal kann unterschiedlich zu einem, zwei, drei, vier oder mehr der weiteren emulierten Empfangskreis-Signale ausgestaltet sein und/oder teilweise (insbesondere zu mindestens 20, 40, 60 oder 80 und/ oder höchstens 99, 95 oder 90 Prozent) mit diesen identisch sein. Die ein, zwei, drei, vier oder mehr der weiteren emulierten Empfangskreis-Signale können mit Vorteil unterschiedlich zueinander ausgestaltet sein und/oder teilweise (insbesondere zu mindestens 20, 40, 60 oder 80 und/ oder höchstens 99, 95 oder 90 Prozent) identisch sein. Nach einer Variante unterscheiden sich die ein, zwei, drei, vier oder mehr der weiteren emulierten Empfangskreis-Signale in Bezug auf denselben Teil oder in Bezug auf jeweils unterschiedliche Teile des ersten Empfangskreis-Signals voneinander. Dies erlaubt es, zu eruieren, welcher Teil des ersten Empfangskreis-Signals allenfalls inkorrekt erzeugt, weitergeleitet oder weiterverarbeitet wird. Nicht jeder Fehler muss zwangsläufig so gravierend sein, dass die Vorrichtung ausgetauscht werden muss.

Die Vorrichtung, insbesondere das Detektorelement, kann einen Speicher aufweisen, wobei der Speicher (insbesondere unterschiedliche Teile des Speichers) durch die Verwendung unterschiedlicher emulierter Empfangskreis-Signale getestet wird (werden). Beispielsweise kann der Speicher eine Speichergrösse von 'n' Bit aufweisen und es können mehrere (beispielsweise 'n') unterschiedliche Empfangskreis-Signale erzeugt werden, die sich nur jeweils in einem Bit voneinander unterscheiden. So kann jedes Bit des Speichers getestet werden.

Schliesslich weist der Sensor eine Recheneinheit auf. Die Recheneinheit ist zweckmässigerweise zur Auswertung des ersten und/ oder des emulierten Ausgangs-Signals ausgebildet und/oder zur Steuerung des Umschaltelements und/ oder zur Steuerung des Signalemulators.

Die Recheneinheit kann einen oder mehrere Logikeinheiten, Mikroprozessoren, ASICs ("application-specific integrated circuit"), CPLDs ("complex programmable logic device") und/oder FPGAs ("field-programmable gate array") umfassen.

Die Recheneinheit kann mit dem Umschaltelement verbunden sein, wobei die Recheneinheit dazu ausgebildet ist, ein erstes Steuersignal zur Steuerung des Umschaltelements zu erzeugen und an das Umschaltelement zu übermitteln. Die Umschaltung zwischen Normalbetrieb und Testbetrieb kann dann in Abhängigkeit des ersten Steuersignals erfolgen.

Alternativ oder zusätzlich kann die Recheneinheit mit dem Signalemulator verbunden sein. Die Recheneinheit kann dazu ausgebildet sein, ein zweites Steuersignal zur Steuerung des Signalemulators zu erzeugen und an dan Signalemulator zu übermitteln. Die Erzeugung des emulierten Empfangskreis-Signals kann dann aus und/ oder in Abhängigkeit des zweiten Steuersignals vom Signalemulator erzeugt werden.

Die Auswertung der Ausgangs-Signale erfolgt mit Vorteil durch die Recheneinheit. In Abhängigkeit des ersten Ausgangs-Signals kann zum Beispiel ein Freigabe-Signal erzeugt werden und/oder in Abhängigkeit des zweiten Ausgangs-Signals kann ein Fehler-Signal erzeugt werden.

Die Recheneinheit dann in Abhängigkeit eines oder mehrerer der empfangenen Ausgangs-Signale Massnahmen einleiten wie sie weiter oben beschrieben wurden. Insbesondere kann die Recheneinheit zwei oder mehr Ausgangssignale (zum Beispiel das erste Ausgangs-Signal mit dem zweiten Ausgangs-Signal) vergleichen, wobei in Abhängigkeit des Vergleichsergebnisses die besagten Massnahmen eingeleitet werden.

Alternativ oder zusätzlich kann die Recheneinheit das zweite Empfangskreis-Signal oder das zweite Steuersignal mit dem zweiten Ausgangs-Signal vergleichen, wobei in Abhängigkeit des Vergleichsergebnisses die besagten Massnahmen eingeleitet werden.

Beim Betätiger kann es sich zum Beispiel um einen Transponder (insbesondere RFID Sensorprinzip) oder ein Metall (insbesondere induktives Sensorprinzip) oder ein magnetisches oder dielektrisches Material (insbesondere kapazitives Sensorprinzip) handeln.

Das Sensorelement ist dazu ausgebildet, während des Normalbetriebs mit dem Betätiger zur Erzeugung des ersten Empfangskreis-Signals zusammenwirken, wenn eine Schaltentfernung zwischen Sensor und Betätiger unterschritten wird, wobei das erste Empfangskreis-Signal an das Detektorelement übermittelt wird.

Ein Verfahren zur Prüfung einer Vorrichtung wie sie in diesem Dokument beschrieben ist, kann sich durch die folgenden Schritte auszeichnen: Umschalten der Vorrichtung mittels des Umschaltelements vom Normalbetrieb auf den Testbetrieb; Erzeugen des emulierten Empfangskreis-Signals durch den Signalemulator und/oder die Recheneinheit und Übermittlung des emulierten Empfangskreis-Signals an das Detektorelement; Erzeugung eines emulierten Ausgangs-Signals aus und/oder in Abhängigkeit des emulierten Empfangskreis-Signals (insbesondere durch Decodierung des emulierten Empfangskreis-Signals) mittels des Detektorelements; und Übermittlung des emulierten Ausgangs-Signals an die Recheneinheit.

Zweckmässigerweise wird das Sensorelement beim Umschalten vom Normalbetrieb auf den Testbetrieb mittels des Umschaltelements vollständig vom Detektorelement getrennt.

Während des Testbetriebs können von der Recheneinheit mit Hilfe des Signalemulators eines oder mehrere unterschiedliche emulierte Empfangskreis-Signale erzeugt werden, welche dann an das Detektorelement übermittelt werden.

Vorzugsweise werden während desselben oder während aufeinanderfolgender Testbetriebe mehrere unterschiedliche emulierte Empfangskreis-Signale erzeugt. In Abhängigkeit von den emulierten Empfangskreis-Signalen werden dann vorzugsweise vom Detektorelement unterschiedliche emulierte Ausgangs-Signale erzeugt und an die Recheneinheit übermittelt.

Es kann vorgesehen sein, dass durch den Signalemulator das Verhalten des Sensorelements nachgebildet wird. Insbesondere kann zu diesem Zweck das vom Signalemulator erzeugte zweite Empfangskreis-Signal im Wesentlichen wie das vom Sensorelement erzeugte erste Empfangskreis-Signal ausgestaltet sein.

Testbetrieb und Normalbetrieb können einander mehrfach (insbesondere periodisch oder aperiodisch und/oder mindestens 2, 5, 10 oder 100 Mal) abwechseln. Nach einer Variante kann der zeitliche Abstand zwischen zwei aufeinanderfolgenden Testbetriebszuständen und/oder zwei aufeinanderfolgenden Normalbetriebszuständen konstant sein. Der Testbetrieb kann (muss aber nicht zwangsläufig) kürzer als der Normalbetrieb sein.

Es ist von Vorteil, wenn sich die Vorrichtung nicht im Testbetrieb befindet, wenn sie sich im Normalbetrieb befindet und/oder wenn sie sich nicht im Normalbetrieb befindet, wenn sie sich im Testbetrieb befindet.

Begriffe in diesem Dokument sollen bevorzugt so verstanden werden, wie sie ein Fachmann auf dem Gebiet verstehen würde. Sind im jeweiligen Kontext mehrere Interpretationen möglich, so sei vorzugsweise jede Interpretation individuell offenbart. Insbesondere für den Fall, dass Unklarheiten bestehen sollten, können alternativ oder ergänzend die in diesem Dokument aufgeführten bevorzugten Definitionen herangezogen werden.

Vorzugsweise erfüllt die Vorrichtung im Normalbetriebszustand (kurz "Normalbetrieb") eine Funktion und im Testbetriebszustand (kurz "Testbetrieb") wird die Fähigkeit der Vorrichtung, die besagte Funktion zu erfüllen, getestet. Alternativ oder zusätzlich ist unter dem "Testbetrieb" vorzugsweise der Zustand der Vorrichtung zu verstehen, der vorwiegend oder vollständig der Prüfung der Funktion der Vorrichtung dient, und unter dem "Normalbetrieb" ist der Zustand zu verstehen, der nicht der Testbetrieb ist.

Der Begriff "verbunden" kann vorzugsweise bedeuten, dass die als "verbunden" bezeichneten Komponenten über eine Leitung verbunden sind. Der Begriff "verbindbar" kann vorzugsweise bedeuten, dass die als "verbindbar" bezeichneten Komponenten über eine mit einem Schalter versehene Leitung miteinander verbunden sind, wobei mittels des Schalters ein Unterbruch der Leitung herbeiführbar ist.

Wenn davon die Rede ist, dass der Sensor bestimmte Komponenten aufweist, so kann dies mit Vorteil bedeuten, dass diese Komponenten zusammengebaut (insbesondere im selben Gehäuse angeordnet) und in diesem Zustand als eine Einheit handhabbar (z.B. transportierbar oder verkäuflich) sind. Dasselbe gilt für den Betätiger.

Zur einfacheren Bezugnahme sei bei Erwähnung des zweiten oder eines emulierten Empfangskreis-Signals vorzugsweise das zweite Empfangskreis-Signal und/oder ein drittes und/oder viertes, etc. (oder allgemein ein "n-tes", wobei n>1) Empfangskreis-Signal offenbart. Entsprechend sei bei Erwähnung eines zweiten oder eines emulierten Ausgangs-Signals vorzugsweise das zweite Ausgangs-Signal und/oder ein drittes und/ oder viertes, etc. (oder allgemein ein "n-tes", wobei n>1) Ausgangs-Signal offenbart. Wenn davon die Rede ist, aus und/oder in Abhängigkeit eines Empfangskreis-Signals würde ein Ausgangs-Signal erzeugt, so sei vorzugsweise die Erzeugung eines Ausgangs-Signals offenbart, das die gleiche Nummer trägt wie das Empfangskreis-Signal (also beispielsweise das vierte Ausgangs-Signal aus dem vierten Empfangskreis-Signal).

Bei Erwähnung eines zweiten Steuersignals sei vorzugsweise das zweite Steuer-Signal und/oder ein drittes und/oder viertes, etc. (oder allgemein ein "n-tes", wobei n>1) Steuer-Signal offenbart. Wenn davon die Rede ist, aus einem und/oder in Abhängigkeit eines zweiten Steuersignals werde ein Empfangskreis-Signal erzeugt, so sei vorzugsweise die Erzeugung eines Empfangskreis-Signals offenbart, das die gleiche Nummer trägt wie das Steuer-Signal.

Aktionen, die in der Form von Eignungen, Fähigkeiten, Eigenschaften oder Funktionen der in diesem Dokument beschriebenen Vorrichtung (oder deren Teile) offenbart sind, seien auch (unabhängig und in beliebiger Kombination) als Verfahrensschritte des Verfahrens offenbart und zwar abhängig und unabhängig von der entsprechenden Vorrichtung oder dem entsprechenden Vorrichtungsteil.

Es sei zudem die Verwendung von Merkmalen der beschriebenen Vorrichtungen oder Vorrichtungsteile (unabhängig und in beliebiger Kombination) als Verfahrensschritte des Verfahrens offenbart.

Umgekehrt können die offenbarten Vorrichtungen oder Vorrichtungsteile Mittel aufweisen, die einen oder mehrere der im Zusammenhang mit dem offenbarten Verfahren genannten Verfahrensschritte durchführen können und/ oder dazu ausgebildet sind.

Merkmale von Ausgestaltungsvarianten, die in der Einleitung im Zusammenhang mit dem Stand der Technik beschrieben sind, seien auch als optionale Merkmale der Erfindung offenbart.

### Kurze Beschreibung der Zeichnungen

Es zeigt in schematischer, nicht massstabsgetreuer Darstellung:
- Fig. 1: eine Vorrichtung zum Überwachen einer Schliessposition zweier relativ zueinander beweglicher Teile gemäss Stand der Technik;
- Fig. 2: drei Diagramme zur Illustration der Funktionsweise der Vorrichtung aus Fig.1, wobei Diagramm 12 einen Datenfluss aus Datenpaketen im Empfangskreis-Signal, Diagramm 13 zwei Betriebszustände der Vorrichtung und die symbolische Empfangskreis-Signalstärke, und Diagramm 14 zwei Betriebszustände des Detektorelements der Vorrichtung darstellen;
- Fig. 3: eine Ausgestaltungsform einer Vorrichtung zum Überwachen einer Schliessposition zweier relativ zueinander beweglicher Teile gemäss der Erfindung;
- Fig. 4: zwei Diagramme zur Illustration der Funktionsweise der Vorrichtung aus Fig.3, wobei Diagramm 15 einen Datenfluss aus Datenpaketen im Empfangskreissignal einschliesslich Datenpakete, die von einem Signalemulator stammen und Diagramm 16 zwei Betriebszustände des Detektorelementes der Vorrichtung darstellen;
- Fig. 5: eine Variante der Vorrichtung aus Fig.3 mit mehreren Betätigern;
- Fig. 6: eine Variante der Vorrichtung aus Fig.3 mit mehreren Sensoren; und
- Fig. 7: eine Variante der Vorrichtung aus Fig.3 mit mehreren Betätigern und mehreren Sensoren;

### Ausführung der Erfindung

Die Erfindung wird nachfolgend anhand der Zeichnungen beispielhaft erläutert.

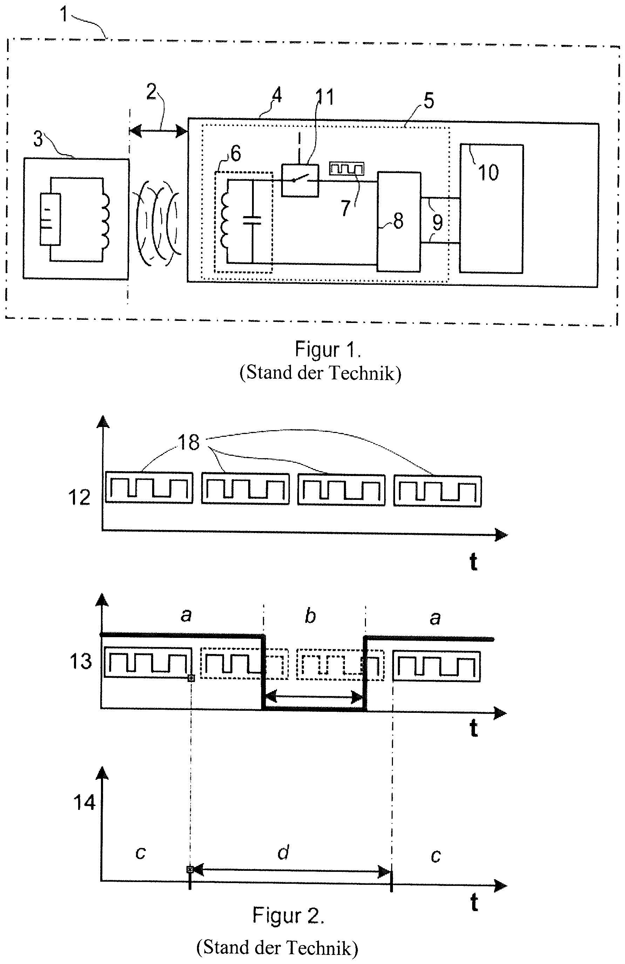

**Fig.1** zeigt eine Vorrichtung 1 zum sicheren Überwachen einer Schliessposition zweier relativ zueinander beweglicher Teile 3,4 gemäss Stand der Technik, wie sie aus der EP 1647094 B1 bekannt ist. Solche Vorrichtungen werden insbesondere zur Verwendung als Türkontaktschalter bei einer Schutztür zum Absichern einer automatisiert arbeitenden technischen Anlage verwendet.

Die Vorrichtung 1 beinhaltet einen Betätiger 3 und einen Sensor 4. Der Sensor 4 weist einen Empfangskreis 5 auf, der bei unterschreiten einer Schaltentfernung 2 zwischen Sensor 4 und Betätiger 3 mit Hilfe eines Sensorelements 6 ein definiertes Empfangskreis-Signal 7 erzeugt. Weiter weist der Empfangskreis 5 ein Detektorelement 8 auf, das bei Vorliegen des definierten Empfangskreis-Signals 7 ein Ausgangs-Signal 9 für eine nachgeschaltete Logikeinheit 10 bereitstellt.

Bei solchen sicheren elektronischen Türkontaktschaltern (z.B. sichere Näherungsschalter, sichere Verriegelungseinheit) ist eine periodische Prüfung der korrekten sensorischen Funktion notwendig, um die geforderte Sicherheitskategorie (z.B. Kat 4, PLe nach EN 13849-1) erreichen zu können.

Zu diesem Zweck weist die Vorrichtung 1 ein Testelement 11 auf, bei dem es sich um ein Schaltelement handelt. Das Testelement 11 erlaubt es, den Empfangskreis 5 zu unterbrechen und so das Empfangskreis-Signal 7 kurzzeitig zu unterdrücken. Durch die Unterbrechung des Empfangskreises 5 mittels des Testelements 11 wird (absichtlich) ein Fehler in Form eines Signal-Mangels im Empfangskreis 5 verursacht. Dadurch wird emuliert, wie das System reagieren würde, wenn der Betätiger 3 sich ausserhalb der Reichweite des Sensors 4 befinden würde. So wird überprüft, ob das Detektorelement 8 nicht nur ein statisches, möglicherweise fehlerhaftes Ausgangs-Signal 9 an die Logikeinheit 10 liefert.

Bei dieser Art der Diagnose kann der Sensor 4 jedoch nicht imitiert werden, wodurch keine Aussage über die korrekte Weiterverarbeitung eines beliebigen korrekten oder inkorrekten Empfangskreis-Signals 7 insbesondere durch das Detektorelement 8 getroffen werden kann. Weiterhin wird die Reaktionszeit des Empfangskreises 5 durch die kurzzeitigen Unterdrückungen des definierten Empfangskreis-Signals 7 nachteilig verlängert.

Das vorgängig Beschriebene wird in Fig. 2 (enthaltend Diagramme 12,13 und 14) genauer erklärt.

Das Diagramm 12 zeigt das Empfangskreis-Signal 7 in Abhängigkeit der Zeit, wobei das Empfangskreis-Signal 7 im dargestellten Zeitintervall durch eine kontinuierliche Abfolge von Datenpaketen 18 gebildet ist. Ein solcher ungestörter Datenfluss wird nur dann entstehen, wenn sich der Betätiger 3 innerhalb der Reichweite des Sensors 4 befindet.

Das Diagramm 13 zeigt das Empfangskreis-Signal 7 in Abhängigkeit der Zeit, wobei das Empfangskreis-Signal 7 im dargestellten Zeitintervall durch eine diskontinuierliche Abfolge von Datenpaketen 18 gebildet ist. Die Signalstärke des Empfangskreis-Signals 7 ist symbolisch durch die dicke Linie dargestellt. Das Zeitintervall enthält zwei Betriebszustände "a" (Normalbetrieb) und "b" (Testbetrieb) der Vorrichtung.

Im Betriebszustand "a" verbindet das Testelement 11 das Sensorelement 6 mit dem Detektorelement 8.

Im Betriebszustand "b" trennt das Testelement 11 das Sensorelement 6 vom Detektorelement 8, wodurch das Empfangskreis-Signal 7 unterbrochen wird, d.h. z. B. die Signalstärke des Empfangskreis-Signals 7 ist während des Unterbruchs null. Für das Detektorelement 8 sind eines oder mehrere Datenpakete 18 während des Betriebszustandes "b" nicht erkennbar und in der Folge wird kein gültiges Ausgangs-Signal 9 an die nachfolgende Logikeinheit 10 bereitgestellt. Die Logikeinheit 10 dient zur Prüfung, ob während des Betriebszustands "b" (korrekterweise) kein gültiges Ausgangs-Signal 9 empfangen wird.

Diese Trennung des Sensorelementes 6 vom Detektorelement 8 wird nicht mit dem Empfang der Datenpakete 18 durch das Detektorelement 8 synchronisiert. Deswegen können im Betriebszustand "b" gegebenenfalls unnötig viele Datenpakete 18 verloren gehen. Diese nicht gültigen Datenpakete 18 werden im Diagramm 13 mit Strichpunkten dargestellt.

Diagramm 14 teilt das Zeitintervall aus Diagramm 13 in die Zeitintervalle "c" und "d" auf, wobei während der Intervalle "c" gültige (vollständige) Datenpakete 18 vom Detektorelement 8 empfangen werden (d.h. der Betätiger 3 wird erkannt; ein Ausgangs-Signal 9 wird erzeugt). Während des Intervalls "d" werden ungültige (unvollständige) Datenpakete 18 oder keine Datenpakete 18 vom Detektorelement 8 empfangen (d.h. der Betätiger 3 wird nicht erkannt; es wird kein Ausgangs-Signal 9 erzeugt).

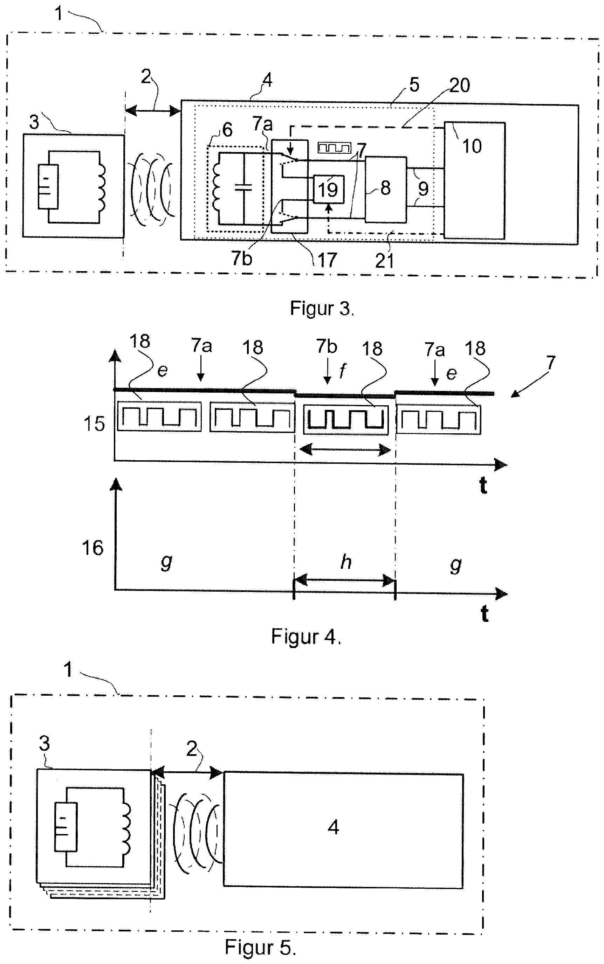

Die **Fig.3-7** erklären die Erfindung anhand eines Ausführungsbeispiels. Zur besseren Vergleichbarkeit mit dem beschriebenen Stand der Technik werden für gleiche Teile gleiche Bezugszeichen wie in den Fig.1-3 verwendet.

**Fig.3** zeigt eine Vorrichtung 1 zum sicheren Überwachen einer Schliessposition zweier relativ zueinander beweglicher Teile, insbesondere zur Verwendung als Türkontaktschalter bei einer Schutztür zum Absichern einer automatisiert arbeitenden technischen Anlage. Die Vorrichtung 1 beinhaltet einen Betätiger 3 und einen Sensor 4. Sie kann aber natürlich auch 2, 3, 4 oder mehr Betätiger und/oder 2, 3, 4 oder mehr Sensoren aufweisen. Der Sensor 4 enthält einen (oder auch 2, 3, 4 oder mehr) Empfangskreis 5, der bei Unterschreiten einer Schaltentfernung 2 zwischen Sensor 4 und Betätiger 3 mit Hilfe eines Sensorelements 6 ein definiertes Empfangskreis-Signal 7a (im Folgenden "erstes Empfangskreis-Signal 7a") erzeugt. Zudem weist der Sensor 4 ein Detektorelement 8 auf, das bei Vorliegen des ersten Empfangskreis-Signals 7a ein erstes Ausgangs-Signal 9a für eine nachfolgende Logikeinheit 10 bereitstellt. Es kann zum Beispiel vorgesehen sein, dass das Detektorelement 8 das erste Empfangskreis-Signal 7a decodiert und dadurch ein decodiertes Informationssignal erzeugt, bei dem es sich um das erste Ausgangs-Signal 9a handelt.

Im Unterschied zum Stand der Technik weist der Empfangskreis 5 im gezeigten Ausführungsbeispiel einen Signalemulator 19 und ein Umschaltelement 17 auf. Sowohl das Sensorelement 6 als auch der Signalemulator 19 sind über das Umschaltelement 17 mit dem Detektorelement 8 verbunden, wobei das Umschaltelement 17 das Sensorelement 6 (oder einen Teil davon) und/oder den Signalemulator 19 mit dem Detektorelement 8 koppeln und vom Detektorelement 8 entkoppeln kann.

Der Signalemulator 19 dient der Erzeugung eines emulierten Empfangskreis-Signals (im Folgenden "zweites Empfangskreis-Signal 7b"), wobei das Detektorelement 8 bei Vorliegen des zweiten Empfangskreis-Signals 7b ein zweites Ausgangs-Signal 9b für die nachfolgende Logikeinheit 10 bereitstellt. Es kann zum Beispiel vorgesehen sein, dass das Detektorelement 8 das zweite Empfangskreis-Signal 7b decodiert und dadurch ein decodiertes Informationssignal erzeugt, bei dem es sich um das zweite Ausgangs-Signal 9b handelt.

Im vorliegenden Beispiel wird die Logikeinheit 10 auch dazu verwendet, den Schaltzustand des Umschaltelements 17 (mittels eines Steuersignals 20) zu steuern und zusammen mit dem Signalemulator 19 das zweite Empfangskreis-Signal 7b zu erzeugen. Es kann zum Beispiel vorgesehen sein, dass es sich beim Detektorelement 8 um einen Transceiver handelt, der eine Trägerwelle erzeugt, wobei die Logikeinheit 10 ein Steuersignal 21 an den Signalemulator 19 übermittelt, das im Signalemulator 19 auf die Trägerwelle aufmoduliert wird, wodurch das zweite Empfangskreis-Signal 7b gebildet wird. Vorzugsweise weist der Signalemulator 19 gleichzeitig gegenüber dem Detektorelement 8 eine definierte Impedanz auf. Die Logikeinheit 10 kann zum vorbeschriebenen Zweck einen oder mehrere Mikroprozessoren, ASICs, CPLDs und/oder FPGAs umfassen, wobei nicht ausgeschlossen ist, ein weiteres separates Element für die Erzeugung von emulierten Empfangskreis-Signalen 7b mit dem Signalemulator 19 zu verwenden. Ein solches Element kann auch einen Prozessor aufweisen.

Im Betriebszustand "e" (Normalbetrieb) der Vorrichtung 1 verbindet das Umschaltelement 17 das Sensorelement 6 mit dem Detektorelement 8. Bei Vorliegen des ersten Empfangskreis-Signals 7a (was bei Unterschreiten einer definierten Schaltentfernung 2 zwischen Sensor 4 und Betätiger 3 der Fall ist) stellt somit das Detektorelement 8 das erste Ausgangs-Signal 9a für die Logikeinheit 10 bereit.

Im Betriebszustand "f" (Testbetrieb) hingegen verbindet das Umschaltelement 17 das Detektorelement 8 mit dem Signalemulator 19. Vorzugsweise wird das Sensorelement 6 oder ein Teil davon (insbesondere die Antenne des Sensorelements) im Betriebszustand "f" mittels des Umschaltelements 17 komplett vom Detektorelement 8 entkoppelt. Der Signalemulator 19 empfängt ein Steuersignal 21, wobei der Empfangskreis 5 mit Hilfe des Signalemulators 19 und in Abhängigkeit des Steuersignals 21 ein zweites Empfangskreis-Signal 7b erzeugt. Das Ausgangs-Signal 9b wird vom Detektorelement 8 in Abhängigkeit des zweiten Empfangskreis-Signals 7b erzeugt. Es können auf die vorbeschriebene Art mit Vorteil verschiedene emulierte Empfangskreis-Signale und/oder unterschiedliche Ausgangs-Signale erzeugt werden.

Gemäss einer Variante können unterschiedliche Steuersignale (vorzugsweise durch die Logikeinheit 10, aber optional auch eine andere Vorrichtungskomponente) erzeugt und an den Signalemulator 19 übermittelt werden, wobei in Abhängigkeit vom Steuersignal ein emuliertes Empfangskreis-Signal erzeugt wird. Vorzugsweise können in Abhängigkeit von der Steuerung der Logikeinheit 10 und/oder vom Signalemulator 19 sowohl einfache wie auch komplexe emulierte Empfangskreis-Signale erzeugt werden. Zum Beispiel kann vorgesehen sein, dass während des Testbetriebs (Betriebszustand "f") ein emuliertes Empfangskreis-Signal erzeugt wird, das aus einer Abfolge von gleichen oder von unterschiedlichen Datenpaketen 18 gebildet ist. Durch die unterschiedliche Gestaltung der Datenpakete 18 kann mit Vorteil eine Dynamik in Inhalt oder in der Signalstärke erzeugt werden.

Im Testbetrieb (Betriebszustand "f") kann die Logikeinheit 10 über den Signalemulator 19 zum Beispiel eine Emulation des ersten Empfangskreis-Signals 7a (d.h. des definierten Empfangskreis-Signals, welches im Normalbetrieb erzeugt wird) vornehmen und so das entkoppelte Sensorelement 6 mittels Emulation nachbilden. Dadurch dass die Logikeinheit 10 das zweite Empfangskreis-Signal 7b kennt, weiss sie auch, welches Ausgangs-Signal 9b sie vom Detektorelement 8 empfangen sollte und kann somit die Empfangskette, darunter insbesondere das Detektorelement 8, testen. Es wird zudem ermöglicht, das Verhalten des Sensorelements 6 mit diskreten Bauteilen nachzubilden, d.h. die Wirkung des Betätigers auf das Detektorelement im Sensor durch elektronische Komponenten zu imitieren.

Das vorgängig Beschriebene wird in **Fig. 4** (enthaltend Diagramme 15 und 16) genauer erklärt.

Das Diagramm 15 zeigt das Empfangskreis-Signal 7 in Abhängigkeit der Zeit, wobei das Empfangskreis-Signal 7 im dargestellten Zeitintervall durch eine Abfolge von Datenpaketen 18 gebildet ist. Die Signalstärke des Empfangskreis-Signals 7 ist symbolisch durch die dicke Linie dargestellt. Das Zeitintervall enthält zwei Betriebszustände "e" (Normalbetrieb) und "f" (Testbetrieb) der Vorrichtung, wobei der Teil des Empfangskreis-Signals 7, welcher im Betriebszustand "e" erzeugt wird, als erstes Empfangskreis-Signal 7a, und der Teil, der im Betriebszustand "f" erzeugt wird, als zweites Empfangskreis-Signal 7b bezeichnet werden.

Während des Betriebszustands "e" verbindet das Umschaltelement 17 das Sensorelement 6 mit dem Detektorelement 8. Im Betriebszustand "f" trennt das Umschaltelement 17 das Sensorelement 6 vom Detektorelement 8 und verbindet den Detektorelement 8 mit dem Signalemulator 19.

Im Betriebszustand "f" erzeugt der Empfangskreis 5 (mit Hilfe der Logikeinheit 10 und des Signalemulators 19) das zweite Empfangskreis-Signal 7b, wobei die Datenpakete, aus denen das zweite Empfangskreis-Signal 7b gebildet ist, nicht die gleiche Information enthalten, wie die Datenpakete, die das erste Empfangskreis-Signal 7a bilden, welches während des Betriebszustands "e" vom Empfangskreis 5 (bei Unterschreiten der Schaltentfernung 2 mit Hilfe des Sensorelements 6) erzeugt wird. Jedoch besitzen die Datenpakete des zweiten Empfangskreis-Signals 7b und des ersten Empfangskreis-Signals 7a das gleiche Datenformat. Die Signalstärke des zweiten Empfangskreis-Signals 7b kann durch den Signalemulator 19 Datenpaket für Datenpaket 18 unterschiedlich gestaltet werden. Weiterhin ist es möglich, Beginn und/ oder Ende des Betriebszustands "f" mit der Abfolge von Datenpaketen 18 des ersten Empfangskreis-Signals 7a und/oder des zweiten Empfangskreis-Signals 7b zu synchronisieren, um weniger Datenpakete 18 zu verlieren. So wird die Testfunktion von der oben genannten Vorrichtung 1 erfüllt und trotzdem eine schnelle Reaktionszeit (schnellere Auswertung des Empfangskreis-Signals 7) gewährleistet.

Diagramm 16 teilt das Zeitintervall aus Diagramm 15 in die Zeitintervalle "g" und "h" auf, wobei während der Intervalle "g" gültige (vollständige) Datenpakete 18 des ersten Empfangskreis-Signals 7a vom Detektorelement 8 empfangen werden (d.h. der Betätiger 3 wird erkannt; ein dem ersten Empfangskreis-Signal 7a zugeordnetes erstes Ausgangs-Signal 9 wird erzeugt). Während des Intervalls "h" werden mit Hilfe des Signalemulators 19 erzeugte Datenpakete 18 des zweiten Empfangskreis-Signals 7b vom Detektorelement 8 empfangen (d.h. ein emulierter Betätiger (mit anderem Code-Inhalt) wird "erkannt"; ein dem zweiten Empfangskreis-Signal 7b zugeordnetes (anderes) zweites Ausgangs-Signal 9b wird erzeugt). Das Zeitintervall "h" ist wegen der oben erwähnten Synchronisation kürzer als das Zeitintervall "d" in Diagramm 14 der Figur 2, mit den erwähnten Folgen für die Reaktionszeit und Verfügbarkeit.

Die Vorrichtung 1 oder Teile der Vorrichtung können auch mehrkanalig aufgebaut sein, wie nachfolgend anhand der **Fig.5-7** erläutert wird.
**Fig.5** zeigt eine Variante der Vorrichtung 1 mit einem Sensor 4 und mehreren Betätigern 3, wobei der Sensor 4 die mehreren Betätiger 3 erkennt. Jeder Betätiger 3 kann ein den Betätiger 3 gegenüber dem Sensor 4 identifizierendes Teil wie zum Beispiel einen RFID-Tag aufweisen, das dem Sensor 4 erlaubt, die Betätiger 3 zu unterscheiden. Alternativ oder zusätzlich kann die Vorrichtung einen oder mehrere Betätiger aufweisen.

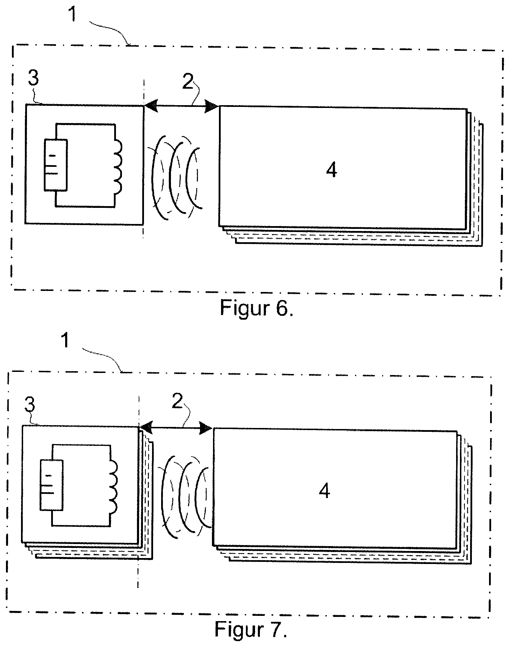

**Fig.6** zeigt eine Variante der Vorrichtung 1 mit mehreren Sensoren 4 und einem Betätiger 3, wobei der Betätiger 3 von den mehreren Sensoren 4 erkannt wird. Alternativ oder zusätzlich kann die Vorrichtung einen oder mehrere spezielle Sensoren aufweisen, bei denen Teile mehrfach vorhanden sind, beispielsweise die mit den Bezugszeichen 5,6,7,8,9,10,17,18,19,20 und/oder 21 bezeichneten Komponenten.
**Fig.7** zeigt eine Variante der Vorrichtung 1 mit mehreren Sensoren 4 und mehreren Betätigern 3. Also eine Kombination aus den in den Fig. 5 und 6 gezeigten Ausführungsformen. Bei dieser Variante werden mehrere Betätiger 3 von mehreren Sensoren 4 erkannt.

### Bezugszeichenliste:

- 1: Vorrichtung
- 2: Schaltentfernung zwischen Betätiger 3 und Sensor 4
- 3: Betätiger
- 4: Sensor
- 5: Empfangskreis
- 6: Sensorelement
- 7: Empfangskreis-Signal
- 7a: erstes Empfangskreis-Signal (Normalbetrieb)
- 7b: zweites Empfangskreis-Signal (Testbetrieb)
- 8: Detektorelement
- 9: Ausgangssignal
- 9a: erstes Ausgangs-Signal (Normalbetrieb)
- 9b: zweites Ausgangs-Signal (Testbetrieb)
- 10: Recheneinheit (insbesondere in der Form einer Logikeinheit)
- 11: Testelement
- 17: Umschaltelement
- 18: Datenpakete
- 19: Signalemulator
- 20: erstes Steuersignal (Steuerung des Umschaltelements 17) 21 zweites Steuersignal (Steuerung des Signalemulators 19)

## Patentansprüche

1. Vorrichtung, insbesondere zur Verwendung als Türkontaktschalter, beinhaltend einen Sensor (4) und einen Betätiger (3), wobei der Sensor (4) einen Empfangskreis (5) mit einem Sensorelement (6), einem Empfangskreis-Signal (7) und einem Detektorelement (8) aufweist, sowie eine mit dem Detektorelement (8) verbndene Recheneinheit (10), wobei
- das Sensorelement (6) dazu ausgebildet ist, während eines Normalbetriebs bei Unterschreiten einer Schaltentfernung (2) zwischen Sensor (4) und Betätiger (3) mit dem Betätiger (3) zur Erzeugung eines ersten Empfangskreis-Signals (7a) zu sammenzuwirken,
- das Detektorelement (8) dazu ausgebildet ist, in Abhängigkeit des ersten Empfangskreis-Signals (7a) ein erstes Ausgangs-Signal (9a) zu erzeugen und an die Recheneinheit (10) zu übermitteln,
- der Empfangskreis (5) zusätzlich einen Signalemulator (19) und ein Umschaltelement (17) aufweist,
- der Signalemulator (19) dazu ausgebildet ist, während eines Testbetriebs ein zweites Empfangskreis-Signal (7b) zu erzeugen,
- das Detektorelement (8) dazu ausgebildet ist, in Abhängigkeit des zweiten Empfangskreis-Signals (7b) ein zweites Ausgangs-Signal (9b) zu erzeugen und an die Recheneinheit (10) zu übermitteln, und
- die Vorrichtung (1) dazu ausgebildet und/oder programmiert ist, mittels des Umschaltelements (17) widerholt, insbesondere periodisch oder aperiodisch, vom Normalbetrieb in den Testbetrieb umzuschalten und jeweils wieder in den Normalbetrieb zurückzuschalten,
**dadurch gekennzeichnet, dass**
das Empfangskreis-Signal (7) durch eine kontinuierliche Abfolge von Datenpaketen (18) gebildet ist.

2. Vorrichtung nach Anspruch 1, **dadurch gekennzeichnet, dass** der Signalemulator (19) dazu ausgebildet ist, während des Testbetriebs zusätzlich zum zweiten Empfangskreis-Signal (7b) ein oder mehrere weitere, sich vom zweiten Empfangskreis-Signal (7b) und/oder voneinander unterscheidende Empfangskreis-Signale zu erzeugen und das Detektorelement (8) dazu ausgebildet ist, in Abhängigkeit von den ein oder mehreren weiteren Empfangskreis-Signalen jeweils ein Ausgangs-Signal zu erzeugen und an die Recheneinheit (10) zu übermitteln.

3. Vorrichtung nach einem der Ansprüche 1 bis 2, **dadurch gekennzeichnet, dass**
- die Recheneinheit (10) mit dem Umschaltelement (17) verbunden ist, wobei die Recheneinheit (10) dazu ausgebildet ist, ein erstes Steuersignal (20) zur Steuerung des Umschaltelements (17) zu erzeugen und an das Umschaltelement (17) zu übermitteln, wobei das Umschaltelement (17) dazu ausgebildet ist, in Abhängigkeit des ersten Steuersignals (20) die Umschaltung zwischen Normalbetrieb und Testbetrieb vorzunehmen, und
- die Recheneinheit (10) mit dem Signalemulator (19) verbunden ist, wobei die Recheneinheit (10) dazu ausgebildet ist, ein zweites Steuersignal (21) zur Steuerung des Signalemulators (19) zu erzeugen und an den Signalemulator (19) zu übermitteln, wobei der Signalemulator (19) dazu ausgebildet ist, in Abhängigkeit des zweiten Steuersignals (21) das zweite Empfangskreis-Signal (7b) zu erzeugen.

4. Vorrichtung nach Anspruch 3, **dadurch gekennzeichnet, dass** das Detektorelement (8) dazu ausgebildet ist, eine Trägerwelle zu erzeugen und der Signalemulator (19) dazu ausgebildet ist, das zweite Steuersignal (21) zur Erzeugung des zweiten Empfangskreis-Signals (7b) auf die Trägerwelle aufzumodulieren.

5. Vorrichtung nach einem der Ansprüche 1 bis 4, **dadurch gekennzeichnet, dass** die Informationen, die vom ersten Empfangskreis-Signal (7a) und vom zweiten Empfangskreis-Signal (7b) transportiert werden, jeweils in der Form einer Abfolge von Datenpaketen (18) strukturiert sind, wobei die Vorrichtung (1) dazu ausgebildet ist, die Umschaltung mittels des Umschaltelements (17) zwischen dem Normalbetrieb und dem Testbetrieb in Abhängigkeit der Abfolge der Datenpakete (18), insbesondere zwischen aufeinanderfolgenden Datenpaketen (18), des ersten Empfangskreis-Signals (7a) und/oder des zweiten Empfangskreis-Signals (7b) vorzunehmen.

6. Vorrichtung nach Anspruch 5, **dadurch gekennzeichnet, dass** die Abfolge der Datenpakete (18) des zweiten Empfangskreis-Signals (7b) unterschiedliche Datenpakete (18) beinhaltet.

7. Vorrichtung nach einem der Ansprüche 1 bis 6, **dadurch gekennzeichnet, dass** es sich bei der Vorrichtung (1) um eine Vorrichtung zur Überwachen einer Schliessposition zweier relativ zueinander beweglicher Teile, wie zum Beispiel einem Türblatt und einer Türzarge, handelt, wobei der Betätiger (3) zur Befestigung am einen der relativ zueinander beweglichen Teile vorgesehen ist und der Sensor (4) zur Befestigung am anderen der relativ zueinander beweglichen Teile vorgesehen ist.

8. Verfahren zur Prüfung einer Vorrichtung nach einem der Ansprüche 1 bis 7, **gekennzeichnet durch** die Schritte:
- Umschalten der Vorrichtung (1) mittels des Umschaltelements (17) vom Normalbetrieb in den Testbetrieb,
- Erzeugen eines zweiten Empfangskreis-Signals (7b) mittels des Signalemulators (19),
- Erzeugen eines zweiten Ausgangs-Signals (9b) in Abhängigkeit des zweiten Empfangskreis-Signals (7b) durch das Detektorelement (8) und Übermitteln des zweiten Ausgangs-Signals (9b) an die Recheneinheit (10),
- wobei mittels des Umschaltelements (17) wiederholt, insbesondere periodisch oder aperiodisch, vom Normalbetrieb in den Testbetrieb und jeweils wieder zurück in den Normalbetrieb umgeschaltet wird.

9. Verfahren nach Anspruch 8, **dadurch gekennzeichnet, dass**
- im Normalbetrieb bei Unterschreiten einer Schaltentfernung (2) zwischen Sensor (4) und Betätiger (3) durch das Zusammenwirken des Sensorelements (6) mit dem Betätiger (3) ein erstes Empfangskreis-Signal (7a) erzeugt wird, und
- durch das Detektorelement (8) in Abhängigkeit des ersten Empfangskreis-Signals (7a) ein erstes Ausgangs-Signal (9a) erzeugt und an die Recheneinheit (10) übermittelt wird, und
- das erste Ausgangs-Signal (9a) durch die Recheneinheit (10) mit dem zweiten Ausgangs-Signal (9b) vergleichen wird.

10. Verfahren nach Anspruch 9, **dadurch gekennzeichnet, dass**
- die Informationen, die vom ersten Empfangskreis-Signal (7a) transportiert werden, in der Form einer Abfolge von Datenpaketen (18) strukturiert sind, und
- das Umschalten der Vorrichtung (1) mittels des Umschaltelements (17) vom Normalbetrieb in den Testbetrieb zwischen aufeinanderfolgenden Datenpaketen (18) des ersten Empfangskreis-Signals (7a) erfolgt.

11. Verfahren nach Anspruch 9 oder 10, **dadurch gekennzeichnet, dass**
- die Informationen, die vom zweiten Empfangskreis-Signal (7b) transportiert werden, in der Form einer Abfolge von Datenpaketen (18) strukturiert sind, und
- das Umschalten der Vorrichtung (1) mittels des Umschaltelements (17) vom Testbetrieb in den Normalbetrieb zwischen aufeinanderfolgenden Datenpaketen (18) des zweiten Empfangskreis-Signals (7b) erfolgt.

12. Verfahren nach einem der Ansprüche 8 bis 11, **dadurch gekennzeichnet, dass** vom Signalemulator (19) mehrere unterschiedliche Empfangskreis-Signale erzeugt und in Abhängigkeit von diesen Empfangskreis-Signalen vom Detektorelement (8) unterschiedliche Ausgangs-Signale erzeugt und an die Recheneinheit (10) übermittelt werden, wobei eines oder mehrere dieser Ausgangs-Signale durch die Recheneinheit (10) mit dem ersten Ausgangs-Signal (9a) vergleichen werden.

13. Verfahren nach einem der Ansprüche 8 bis 12, **dadurch gekennzeichnet, dass** durch den Signalemulator (19) das Verhalten des Sensorelements (6) nachgebildet wird, wobei zu diesem Zweck das vom Signalemulator (19) erzeugte zweite Empfangskreis-Signal (7b) im Wesentlichen wie das vom Sensorelement (6) erzeugte erste Empfangskreis-Signal (7a) ausgestaltet ist.

14. Verfahren nach einem der Ansprüche 8 bis 13, **dadurch gekennzeichnet, dass** beim Umschalten vom Normalbetrieb auf den Testbetrieb das Sensorelement (6) mittels des Umschaltelements (17) vollständig vom Detektorelement (8) getrennt wird.

15. Verfahren nach einem der Ansprüche 8 bis 14, **dadurch gekennzeichnet, dass** vom Detektorelement (8) eine analoge Trägerwelle im Empfangskreis (5) erzeugt wird und die Empfangskreis-Signale (7a, 7b) durch Modulation der Trägerwelle erzeugt werden, wobei die Modulation vorzugsweise durch ein digitales Modulationsverfahren durchgeführt wird.

## Claims

1. A device, in particular for use as a door contact switch, containing a sensor (4) and an actuator (3), wherein the sensor (4) has a receiving circuit (5) with a sensor element (6), a receiving circuit signal (7) and a detector element (8), as well as a computer unit (10) connected to the detector element (8), wherein
- the sensor element (6) is configured in order to co-operate with the actuator (3) to generate a first receiving circuit signal (7a) during a normal operation when a switching distance (2) between the sensor (4) and the actuator (3) is undershot,
- the detector element (8) is configured to generate a first output signal (9a) as a function of the first receiving circuit signal (7a), and to transmit this output signal to the computer unit (10),
- the receiving circuit (5) additionally has a signal emulator (19) and a switch-over element (17),
- the signal emulator (19) is configured to generate a second receiving circuit signal (7b) during a test operation,
- the detector element (8) is configured to generate a second output signal (9b) as a function of the second receiving circuit signal (7b), and to transmit this output signal to the computer unit (10),
- the device (1) is configured and/or programmed to switch over from normal operation into test operation and in each case to switch back into normal operation by means of the switch-over element (17) repeatedly, in particular periodically or aperiodically,
**characterized in that** the receiving circuit signal (7) is formed by a continuous succession of data packets (18).

2. The device according to claim 1, **characterized in that** the signal emulator (19) is configured to generate one or more further receiving circuit signals, which differ from the second receiving circuit signal (7b) and/or from one another, in addition to the second receiving circuit signal (7b), during the test operation, and the detector element (8) is configured to generate an output signal in each case as a function of the one or more further receiving circuit signals and to transmit the output signal to the computer unit (10).

3. The device according to one of claims 1 to 2, **characterized in that**
- the computer unit (10) is connected to the switch-over element (17), the computer unit (10) being configured to generate a first control signal (20) for control of the switch-over element (17) and to transmit this signal to the switch-over element (17), wherein the switch-over element (17) is configured to perform the switch-over between normal operation and test operation as a function of the first control signal (20), and
- the computer unit (10) is connected to the signal emulator (19), the computer unit (10) being configured to generate a second control signal (21) for control of the signal emulator (19) and to transmit this signal to the signal emulator (19), - and the signal emulator (19) being configured to generate a second receiving circuit signal (7b) as a function of the second control signal (21).

4. The device according to claim 3, **characterized in that** the detector element (8) is configured to generate a carrier wave and the signal emulator (19) is configured to modulate the second control signal (21) onto the carrier wave in order to generate the second receiving circuit signal (7b).

5. The device according to one of claims 1 to 4, **characterized in that** the information transported by the first receiving circuit signal (7a) and by the second receiving circuit signal (7b) are in each case structured in the form of a succession of data packets (18), wherein the device (1) is configured in order to perform the switch-over by means of the switch-over element (17) between the normal operation and the test operation as a function of the succession the data packets (18), in particular between successive data packets (18), of the first receiving circuit signal (7a) and/or of the second receiving circuit signal (7b).

6. The device according to claim 5, **characterized in that** the succession of data packets (18) of the second receiving circuit signal (7b) contains different data packets (18).

7. The device according to one of claims 1 to 6, **characterized in that** the device (1) is a device for monitoring a closing position of two parts that are movable relative to one another, such as, for example, a door leaf and a door frame, the actuator (3) being provided for fastening to one of the parts that are movable the relative to one another, and the sensor (4) being provided for fastening to the one of the parts that are movable relative to one another.

8. A method for testing a device according to one of claims 1 bis 7, **characterized by** the steps:
- switching of the device (1) from normal operation to test operation by means of the switch-over element (17),
- generating a second receiving circuit signal (7b) by means of the signal emulator (19),
- generating a second output signal (9b) by the detector element (8) as a function of the second receiving circuit signal (7b), and transmitting this output signal to the computer unit (10),
- wherein the switch-over element (17) switches over from normal operation into test operation and in each case back into normal operation repeatedly, in particular periodically or aperiodically.

9. The method according to claim 8, **characterized in that**
- by co-operation with the actuator (3) a first receiving circuit signal (7a) is generated during normal operation when a switching distance (2) between the sensor (4) and the actuator (3) is undershot, and
- a first output signal (9a) is generated by the detector element (8) as a function of the first receiving circuit signal (7a), and this output signal is transmitted to the computer unit (10),
- the first output signal (9a) is compared with the second output signal (9b) by the computer unit (10).

10. The method according to claim 9, **characterized in that**
- the information transported by the first receiving circuit signal (7a) is structured in the form of a succession of data packets (18), and
- the switching of the device (1) from normal operation to test operation by means of the switch-over element (17) takes place between two successive data packets (18) of the first receiving circuit signal (7a).

11. Method according to claim 9 or 10, **characterized in that**
- the information transported by the second receiving circuit signal (7b) is structured in the form of a succession of data packets (18), and
- the switching of the device (1) from test operation to normal operation by means of the switch-over element (17) takes place between two successive data packets (18) of the second receiving circuit signal (7b).

12. The method according to one of claims 8 to 11, **characterized in that** the signal emulator (19) generates a plurality of different receiving circuit signals and, as a function of these receiving circuit signals, different output signals are generated by the detector element (8) and are transmitted to the computer unit (10), one or more of these output signals being compared by the computer unit (10) with the first output signal (9a).

13. The method according to one of claims 8 to 12, **characterized in that** the behavior of the sensor element (6) is simulated by the signal emulator (19), wherein for this purpose the second receiving circuit signal (7b) generated by the signal emulator (19) is configured substantially like the first receiving circuit signal (7a) generated by the sensor element (6).

14. The method according to one of claims 8 to 13, **characterized in that** during switching from normal operation to test operation the sensor element is completely separated from the detector element by means of the switch-over element.

15. The method according to one of claims 8 to 14, **characterized in that** the detector element (8) generates an analog carrier wave in the receiving circuit (5) and the receiving circuit signals (7a, 7b) are generated by modulation of the carrier wave, the modulation preferably being carried out by a digital modulation method.

## Revendications

1. Dispositif, en particulier pour l'utilisation comme contacteur de porte, qui contient un détecteur (4) et un actionneur (3), cependant que le détecteur (4) présente un circuit de réception (5) avec un élément capteur (6), un signal de circuit de réception (7) et un élément détecteur (8) ainsi qu'une unité de calcul (10) reliée à l'élément détecteur (8), cependant que
- l'élément capteur (6) est configuré pour coopérer avec l'actionneur (3) pour produire un premier signal de circuit de réception (7a) pendant un fonctionnement normal dans le cas où une distance de commutation (2) entre le détecteur (4) et l'actionneur (3) n'est pas atteinte,
- l'élément détecteur (8) est configuré pour produire un premier signal de sortie (9a) en fonction du premier signal de circuit de réception (7a) et pour le transmettre à l'unité de calcul (10),
- le circuit de réception (5) présente en plus un émulateur de signal (19) et un élément de commutation (17),
- l'émulateur de signal (19) est configuré pour produire un second signal de circuit de réception (7b) pendant un fonctionnement test,
- l'élément détecteur (8) est configuré pour produire un second signal de sortie (9b) en fonction du second signal de circuit de réception (7b) et pour le transmettre à l'unité de calcul (10) et
- le dispositif (1) est configuré et/ou programmé pour commuter de manière répétée, en particulier de manière périodique ou non, du fonctionnement normal au fonctionnement test, au moyen de l'élément de commutation (17) et de retourner respectivement au fonctionnement normal,
**caractérisé en ce que** le signal de circuit de réception (7) est formé par une séquence continue de paquets de données (18).

2. Dispositif selon la revendication 1, **caractérisé en ce que** l'émulateur de signal (19) est configuré pour produire pendant le fonctionnement test, en plus du second signal de circuit de réception (7b), un ou plusieurs autres signaux de circuit de réception qui se distinguent du second signal de circuit de réception (7b) et/ou l'un de l'autre et l'élément détecteur (8) est configuré pour produire respectivement un signal de sortie en fonction de l'un ou de plusieurs autres signaux de circuit de réception et pour le(s) transmettre à l'unité de calcul (10).

3. Dispositif selon l'une des revendications 1 à 2, **caractérisé en ce que**
- l'unité de calcul (10) est reliée à l'élément de commutation (17), cependant que l'unité de calcul (10) est configurée pour produire un premier signal de commande (20) pour la commande de l'élément de commutation (17) et pour le transmettre à l'élément de commutation (17), cependant que l'élément de commutation (17) est configuré pour effectuer, en fonction du premier signal de commande (20), la commutation entre fonctionnement normal et fonctionnement test et
- l'unité de calcul (10) est reliée à l'émulateur de signal (19), cependant que l'unité de calcul (10) est configurée pour produire un second signal de commande (21) pour la commande de l'émulateur de signal (19) et pour le transmettre à l'émulateur de signal (19), cependant que l'émulateur de signal (19) est configuré pour produire, en fonction du second signal de commande (21), le second signal de circuit de réception (7b).

4. Dispositif selon la revendication 3, **caractérisé en ce que** l'élément détecteur (8) est configuré pour produire une onde porteuse et l'émulateur de signal (19) est configuré pour moduler le second signal de commande (21) pour produire le second signal de circuit de réception (7b) sur l'onde porteuse.

5. Dispositif selon l'une des revendications 1 à 4, **caractérisé en ce que** les informations qui sont transportées par le premier signal de circuit de réception (7a) et par le second signal de circuit de réception (7b) sont structurées respectivement sous forme d'une séquence de paquets de données (18), cependant que le dispositif (1) est configuré pour effectuer la commutation au moyen de l'élément de commutation (17) entre le fonctionnement normal et le fonctionnement test en fonction de la séquence des paquets de données (18), en particulier entre des paquets de données successifs (18), du premier signal de circuit de réception (7a) et/ou du second signal de circuit de réception (7b).

6. Dispositif selon la revendication 5, **caractérisé en ce que** la séquence des paquets de données (18) du second signal de circuit de réception (7b) contient différents paquets de données (18).

7. Dispositif selon l'une des revendications 1 à 6, **caractérisé en ce qu'**il s'agit, pour le dispositif (1), d'un dispositif pour contrôler une position de fermeture de deux parties mobiles l'une par rapport à l'autre comme, par exemple, un battant de porte et un chambranle, cependant que l'actionneur (3) est prévu pour la fixation à l'une des parties mobiles l'une par rapport à l'autre et le capteur (4) est prévu pour la fixation à l'autre des parties mobiles l'une par rapport à l'autre.

8. Procédé pour contrôler un dispositif selon l'une des revendications 1 à 7, **caractérisé par** les étapes :
- commutation du dispositif (1) au moyen de l'élément de commutation (17) de fonctionnement normal à fonctionnement test,
- production d'un second signal de circuit de réception (7b) au moyen de l'émulateur de signal (19),
- production d'un second signal de sortie (9b) en fonction du second signal de circuit de réception (7b) par l'élément détecteur (8) et transmission du second signal de sortie (9b) à l'unité de calcul (10),
- cependant que la commutation se fait au moyen de l'élément de commutation (17) de manière répétée, en particulier de manière périodique ou non, du fonctionnement normal au fonctionnement test et que la commutation se fait respectivement pour le retour au fonctionnement normal.

9. Procédé selon la revendication 8, **caractérisé en ce que**
- en fonctionnement normal dans le cas où une distance de commutation (2) entre le détecteur (4) et l'actionneur (3) n'est pas atteinte un premier signal de circuit de réception (7a) est produit par la coopération de l'élément capteur (6) avec l'actionneur (3) et
- un premier signal de sortie (9a) est produit par l'élément détecteur (8) en fonction du premier signal de circuit de réception (7a) et est transmis à l'unité de calcul (10) et
- le premier signal de sortie (9a) est comparé par l'unité de calcul (10) au second signal de sortie (9b).

10. Procédé selon la revendication 9, **caractérisé en ce que**
- les informations qui sont transportées par le premier signal de circuit de réception (7a) sont structurées sous forme d'une séquence de paquets de données (18) et
- la commutation du dispositif (1) se fait au moyen de l'élément de commutation (17) de fonctionnement normal à fonctionnement test entre des paquets de données successifs (18) du premier signal de circuit de réception (7a).

11. Procédé selon la revendication 9 ou 10, **caractérisé en ce que**
- - les informations qui sont transportées par le second signal de circuit de réception (7b) sont structurées sous forme d'une séquence de paquets de données (18) et
- la commutation du dispositif (1) se fait au moyen de l'élément de commutation (17) de fonctionnement test à fonctionnement normal entre des paquets de données successifs (18) du second signal de circuit de réception (7b).

12. Procédé selon l'une des revendications 8 à 11, **caractérisé en ce que** plusieurs signaux de circuit de réception différents sont produits par l'émulateur de signal (19) et différents signaux de sortie sont produits en fonction de ces signaux de circuit de réception par l'élément détecteur (8) et sont transmis à l'unité de calcul (10), cependant qu'un ou plusieurs de ces signaux de sortie sont comparés par l'unité de calcul (10) au premier signal de sortie (9a).

13. Procédé selon l'une des revendications 8 à 12, **caractérisé en ce que** le comportement de l'élément capteur (6) est imité par l'émulateur de signal (19), cependant que le second signal de circuit de réception (7b) produit par l'émulateur de signal (19) est configuré à cet effet sensiblement comme le premier signal de circuit de réception (7a) produit par l'élément capteur (6).

14. Procédé selon l'une des revendications 8 à 13, **caractérisé en ce que** lors de la commutation de fonctionnement normal à fonctionnement test l'élément capteur (6) est complètement séparé de l'élément détecteur (8) au moyen de l'élément de commutation (17).

15. Procédé selon l'une des revendications 8 à 14, **caractérisé en ce qu'**une onde porteuse analogique est produite par l'élément détecteur (8) dans le circuit de réception (5) et les signaux de circuit de réception (7a, 7b) sont produits par modulation de l'onde porteuse, cependant que la modulation est de préférence exécutée par un procédé de modulation numérique.
